**Europäisches Patentamt**

(19) **European Patent Office**

**Office européen des brevets**

(11) Numéro de publication: **0 106 722**
**B1**

(12) **FASCICULE DE BREVET EUROPEEN**

(45) Date de publication du fascicule du brevet:
**10.12.86**

(51) Int. Cl.⁴: **C 30 B 1/02,** C 30 B 1/08,
C 30 B 13/24

(21) Numéro de dépôt: **83401724.6**

(22) Date de dépôt: **30.08.83**

(54) **Machine de traitement thermique pour semiconducteur.**

(30) Priorité: **07.09.82 FR 8215182**

(43) Date de publication de la demande:
**25.04.84 Bulletin 84/17**

(45) Mention de la délivrance du brevet:
**10.12.86 Bulletin 86/50**

(84) Etats contractants désignés:
**CH DE GB IT LI NL**

(56) Documents cités:
**EP - A - 0 021 087**
**DE - A - 2 917 353**

**IBM TECHNICAL DISCLOSURE BULLETIN, vol. 19, no. 10, mars 1977, NEW YORK (US),R.J. VON GUTFELD: " Crystallization of silicon for solar cell applications", pages 3955-3956**

(73) Titulaire: **Vu, Duy-Phach, 5, rue de l'Oisans, F-38240 Meylan (FR)**
Titulaire: **Haond, Michel, 9, rue des Lilas, F-38240 Meylan (FR)**

(72) Inventeur: **Vu, Duy-Phach, 5, rue de l'Oisans, F-38240 Meylan (FR)**
Inventeur: **Haond, Michel, 9, rue des Lilas, F-38240 Meylan (FR)**

(74) Mandataire: **Mongrédien, André et al, c/o BREVATOME 25, rue de Ponthieu, F-75008 Paris (FR)**

## Description

La présente invention a pour objet une machine de traitement thermique pour semiconducteurs et un procédé de mise en œuvre. Elle trouve une application dans le recuit de plaquettes semiconductrices et également dans la recristallisation de silicium amorphe ou polycristallin sur isolant.

Une des opérations essentielles de la fabrication de circuits intégrés est le dopage d'un semiconducteur par des atomes donneurs ou accepteurs d'électrons. Cette opération peut s'effectuer par implantation ionique, notamment dans le cas des circuits à couches minces. Cependant, comme l'implantation ionique provoque une destruction de la structure cristalline du semiconducteur, sur une épaisseur de quelques milliers d'Angströms, une reconstruction du réseau cristallin est nécessaire, pour activer électriquement les atomes de l'impureté implantée. Cette reconstruction est obtenue par un recuit qui consiste à porter le semiconducteur à haute température, généralement entre 500 °C et 1100 °C.

Différents moyens de recuit sont connus, à savoir des fours à diffusion de chaleur ou des sources lumineuses cohérentes (lasers), ou encore des faisceaux d'électrons, ou enfin des feuilles de graphite chauffées par effet Joule.

Le recuit par four est utilisé depuis de nombreuses années dans l'industrie des semiconducteurs, mais il ne convient plus guère aux nouvelles conceptions de circuits intégrés où l'objectif essentiel est de porter très haut la densité d'intégration en réduisant les dimensions des composants. En effet, le recuit au four, qui demande 15 à 30 minutes à 500–1100 °C, provoque, par un mécanisme de diffusion, un étalement des impuretés dans les trois dimensions du semiconducteur.

Pour conserver aux zones implantées le profil que leur donne l'implantation, il faut avoir recours à des techniques de recuit plus rapide. Celles qui utilisent des lasers ou des faisceaux d'électrons semblent mieux adaptées à cet égard. Cependant les installations correspondantes sont complexes et coûteuses et elles consomment beaucoup de énergie. Un exemple de telles installations est décoret dans EP-A- 0 021 087.

Le but de l'invention est de fournir une machine de traitement qui soit plus simple et moins coûteuse que les machines antérieures, tout en permettant d'obtenir une élévation rapide de la température du semiconducteur traité, avec une consommation en énergie moindre. L'invention a également pour but un procédé de mise en œuvre de cette machine, tel que défini dans la revendication 9.

Ces buts sont atteints, selon l'invention, par l'utilisation de deux lampes disposées de part et d'autre de la plaquette de semiconducteur à traiter. L'une au moins de ces lampes émet un rayonnement focalisé par un réflecteur sur la face à traiter selon une tache focale, fournissant ainsi une haute densité d'énergie. L'autre lampe émet un rayonnement qui se traduit, sur la face opposée de la plaquette, par une tache concentrique à celle de la tache focale de la face à traiter, de dimensions supérieures et présentant une répartition d'énergie à faible gradient.

Le rôle de cette seconde lampe est de préchauffer la région traitée, à travers la plaquette semiconductrice afin de faciliter le recuit tout en réduisant le gradient thermique dans la plaquette. Ce gradient pourrait engendrer l'apparition de lignes de glissement et des dislocations dans le semiconducteur.

Le rôle de la première lampe est de fournir le complément d'énergie pour effectuer localement le traitement thermique souhaité.

La machine de l'invention peut servir au recuit mais également à la recristallisation de semiconducteurs. Dans ce dernier cas, la seconde lampe est réglée pour émettre un rayonnement peu ou pas focalisé, afin que soit préchauffée la quasi-totalité de la plaquette.

Les caractéristiques de l'invention apparaîtront mieux après la description qui suit, d'exemples de réalisation donnés à titre explicatif et nullement limitatif. Cette description se réfère à des dessins sur lesquels:

— la figure 1 illustre les moyens de chauffage utilisés dans une machine conforme à l'invention,

— la figure 2 représente une vue générale d'une machine conforme à l'invention, dans une variante où le support de plaquette est fixe,

— la figure 3 montre le repère utilisé pour définir un balayage en spirale à vitesse uniforme,

— la figure 4 montre, en coupe, un porte-échantillon pour recuit sous atmosphère contrôlée,

— la figure 5 illustre une variante utilisable pour la recristallisation d'un semiconducteur sur isolant.

Comme toute machine de traitement thermique de plaquettes de semiconducteurs, celle de l'invention comprend des premiers moyens pour chauffer localement une zone de cette plaquette et des seconds moyens pour déplacer cette zone et balayer la totalité de la plaquette. L'invention se caractérise par la structure des premiers moyens et accessoirement par la nature des seconds.

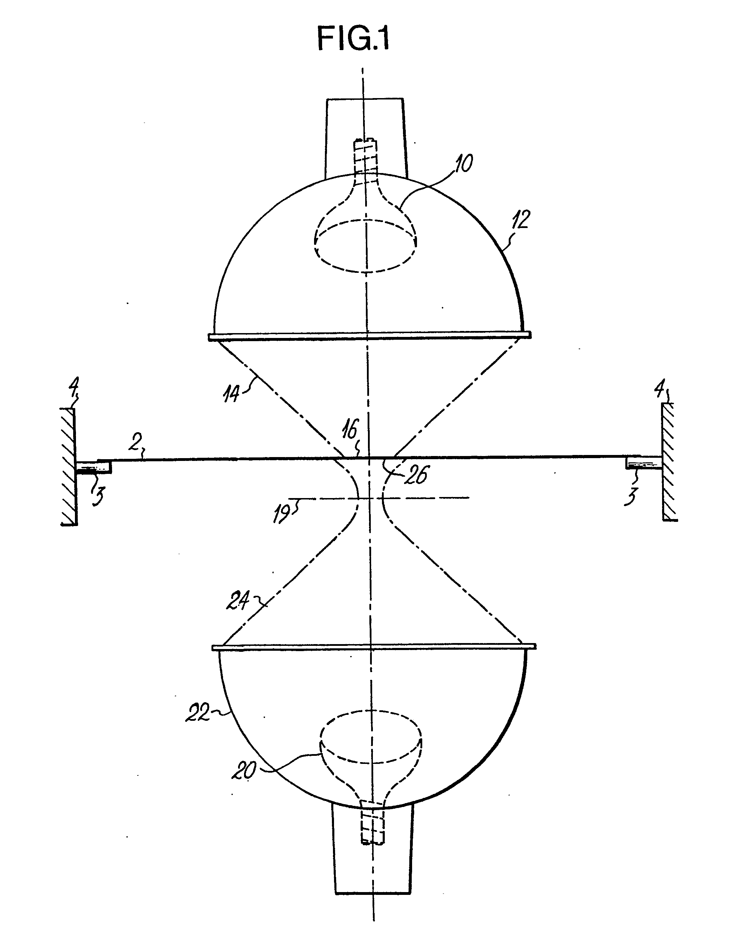

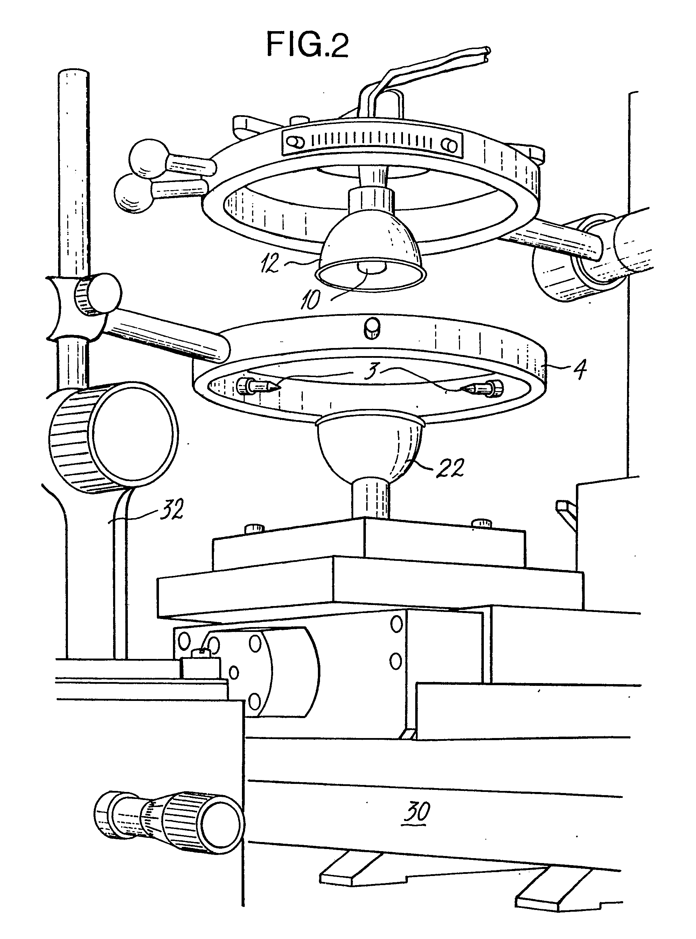

Selon le mode de réalisation représenté sur les figures 1 et 2, une plaquette de semiconducteur 2 repose sur des pointes isolantes 3 (par exemple en céramique), lesquelles sont solidaires d'un support en forme d'anneau 4. Les moyens de chauffage sont constitués par:

— une première lampe 10, placée au-dessus de la plaquette 2 et munie d'un premier réflecteur focalisant 12; cette première lampe émet un premier rayonnement 14 dirigé vers la face supérieure de la plaquette 2 qui est la face à traiter; ce rayonnement est focalisé par le réflecteur selon une tache focale 16 ayant un certain diamètre;

— une seconde lampe 20, placée sous la plaquette 2; cette seconde lampe émet un second rayonnement 24 dirigé vers la face inférieure de la plaquette 2 où il forme une seconde tache 26 ayant un diamètre supérieure à celui de la tache focale 16.

De préférence dans l'application au recuit, la seconde lampe 20 est munie d'un réflecteur 22 identique au réflecteur 12 mais focalisant le second rayonnement 24 sur un plan 19 légèrement décalé par rapport à la face inférieure de la plaquette 2. De cette manière, la seconde lampe remplit le rôle défini précédemment.

Comme on le voit sur l'exemple de la figure 2, les moyens de déplacement de la zone chauffée pour balayer la totalité de la plaquette sont constitués par des moyens de déplacement de l'ensemble des deux lampes, la plaquette restant fixe. Dans ce cas, les lampes sont solidaires d'une table de translation 30 du type x–y commandée par deux moteurs pas à pas non représentés, eux-mêmes actionnés par des signaux provenant d'un circuit de commande approprié. Quant à la plaqette, elle est tenue par son support 4, lequel est solidaire d'un pied 32 fixe.

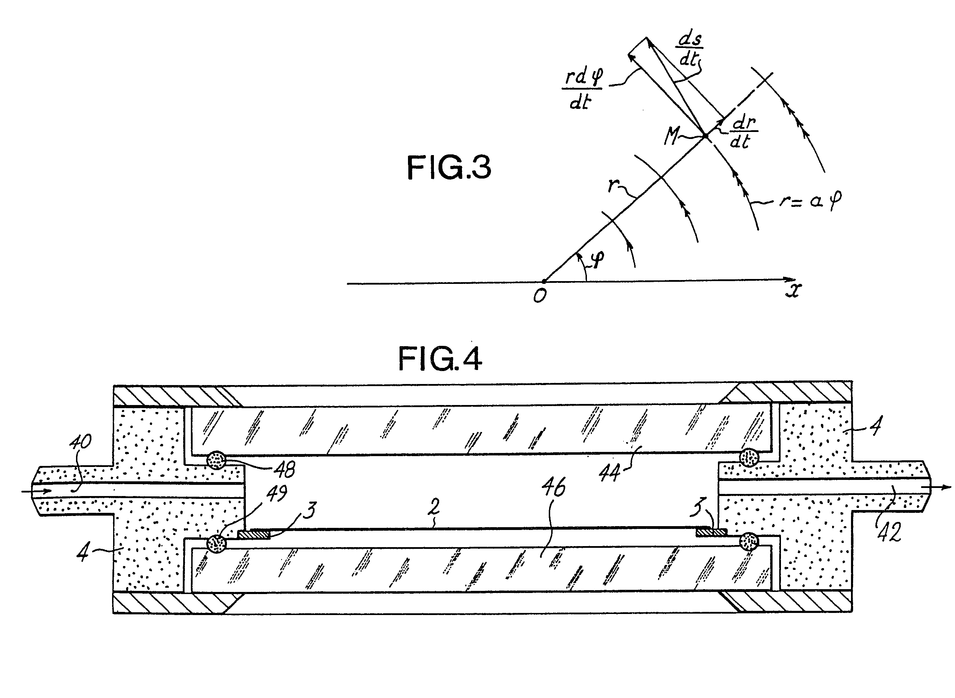

Dans une variante avantageuse, les moyens de balayage présentent cependant une nature originale. Ils sont aptes à provoquer un balayage en forme de spirale d'Archimède, pour laquelle les coordonnées polaires r et $\varphi$ du centre de la première tache par rapport au centre de la plaquette, vérifient la relation $r = a\varphi$ où $\underline{a}$ est une constante; de plus, l'évolution temporelle de l'angle polaire $\varphi$ est de la forme $b\sqrt{t}$, où $\underline{b}$ est une constante et $\underline{t}$ le temps. L'intérêt de ce balayage particulier est que la vitesse linéaire ($v = \dfrac{ds}{dt}$)    est    pratiquement constante en tout point de la spirale. En effet, avec des notations précisées sur la figure 3, on a:

$$r = a\,\varphi \text{ et } \varphi = b\sqrt{t}$$

donc       $r = a \cdot b\sqrt{t}$

Les composantes radiale ($v_r$) et tangentielle ($v_t$) de la vitesse s'écrivent:

$$v_r = \frac{dr}{dt} = \frac{a \cdot b}{2} \cdot \frac{1}{\sqrt{t}}$$

$$v_t = r\frac{d\varphi}{dt} = a \cdot b \cdot \sqrt{t} \cdot b \cdot \frac{1}{2\sqrt{t}} = \frac{a \cdot b^2}{2}$$

$v_t$ est donc indépendante du temps.

Avec les vitesses linéaires habituellement utilisées pour le recuit (quelques mm/s), la composante $v_r$ est rapidement négligeable devant $v_t$. Par suite:

$$v = (v_t^2 + v_r^2)^{1/2} \simeq v_t$$

Un tel mouvement, en spirale d'Archimède à vitesse linéaire constante, peut être obtenu au moyen de deux moteurs pas à pas commandés par un calculateur et agissant sur une table de translation en x–y. Son intérêt est double: d'une part, il conduit à des bras équidistants, ce qui est nécessaire pour pouvoir balayer uniformément la totalité de la plaquette; d'autre part, il évite d'avoir une vitesse qui augmente lorsqu'on atteint la périphérie de la plaquette, ce qui serait le cas avec une loi angulaire linéaire en fonction du temps.

En plus des dispositions originales qui viennent d'être décrites, des moyens peuvent être prévus pour que la température de la plaquette dans la zone focale soit maintenue constante. Ces moyens comprennent un pyromètre optique disposé dans une boucle d'asservissement agissant sur l'alimentation des lampes.

L'asservissement de la température peut être utile lorsque, au fur et à mesure que le spot se rapproche des bords de l'installation, un effet de réflexion de la chaleur se manifeste.

La machine qui vient d'être décrite a été mise en œuvre dans des conditions qui vont maintenant être précisées. Des lampes à halogène à réflecteur incorporé de 150 W chacune, commercialisées par la Société OSRAM (réf. 64 635), ont été utilisées. Un recuit dans l'air ambiant, sous flux laminaire, a été effectué avec les valeurs des paramètres $\underline{a}$ et $\underline{b}$ suivants:

$$a = 1{,}27 \text{ mm/radian}$$
$$b = 2{,}17 \text{ rad/s}^{-1/2}$$

Pour ces valeurs, la distance entre deux lignes recuites consécutives est de 8 mm et la vitesse linéaire de 3 mm/s. La température est maintenue à 1000 °C. Le recuit d'une plaquette de 10 cm dure 5 mm.

Des plaquettes de silicium de 10 cm de diamètre ont été implantées dans les conditions suivantes:

arsenic:       $5 \times 10^{14} \text{ cm}^{-2}$ à   50 keV
              $5 \times 10^{14} \text{ cm}^{-2}$ à 100 keV

phosphore: triple implantation:

$$8 \times 10^{14} \text{ cm}^{-2} \text{ à } 100 \text{ keV}$$
$$+6 \times 10^{14} \text{ cm}^{-2} \text{ à } \phantom{0}80 \text{ keV}$$
$$+4 \times 10^{14} \text{ cm}^{-2} \text{ à } \phantom{0}50 \text{ keV.}$$

La caractérisation des plaquettes obtenues a été réalisée par différentes techniques:
– par mesure de la résistance de couche: cette mesure a permis de révéler une activation complète des atomes d'impureté et une excellente uniformité le long d'un diamètre (écart type de 3,5%);
– par mesure du profil de l'impureté en fonction de la distance à la surface: cette mesure a permis de confirmer que le recuit réalisé ne modifiait pas le profil des dopants résultant de l'implantation;
– par des mesures de planéité à l'aide d'un interféromètre de type Fizeau: aucun voilage appréciable n'a pu être révélé.

De tels résultats constituent un avantage certain pour la machine de l'invention. En effet, pour obtenir une activation totale, il faut, dans un four à 1000 °C, recuire la plaquette pendant au moins 30 mn. Mais, après une telle durée, on constate que le profil des impuretés s'est modifié et que les dopants ont diffusé très loin (plusieurs centaines d'Ångströms pour les couches implantées en arsenic à $5 \times 10^{14}$ et à 100 keV). A propos de ce phénomène parasite de diffusion, on peut se reporter à l'article de A. Gat publié dans la revue «IEEE Electron Device Letters», vol. EDL-2, n° 4, avril 1981, pages 85–87.

Il est possible d'étendre le principe de la machine décrite plus haut à une machine apte à traiter tout un lot de plaquettes. Il suffit pour cela de multiplier le nombre de paires de lampes et de prévoir un support de plaquettes à plusieurs alvéoles recevant chacune une plaquette. Un tel support peut être encore animé d'un mouvement en spirale à vitesse uniforme. Le recuit d'une plaquette de 10 cm de diamètre s'effectuant en 5 minutes, avec 10 alvéoles, on peut traiter 120 plaquettes à l'heure, ce qui est supérieure à ce que permettent les fours à diffusion qui ne dépassent pas 100 plaquettes à l'heure.

La machine de l'invention peut comprendre un support de plaquette permettant un traitement sous atmosphère contrôlée. Un tel support est illustré sur la figure 4. Il comprend encore un anneau isolant 4 pourvu de pointes isolantes 3 (par exemple en céramique) supportant la plaquette 2; il comprend en outre un premier conduit 40 de amenée de gaz et un second conduit 42 de sortie de ce gaz, ces deux conduits traversant l'anneau en des zones diamétralement opposées; deux hublots transparents (44 et 46) sont appliqués sur l'anneau, de part et d'autre de la plaquette, des joints 48–49 assurant l'étanchéité.

Une telle structure permet de travailler sous vide ou sous atmosphère contrôlée. Elle permet la fabrication de siliciures; elle autorise des opérations d'oxydation (oxygène sec ou humide, pour oxydes minces ou épais).

Par ailleurs, la machine de l'invention trouve une autre application dans la technologie silicium sur isolant en permettant la recristallisation de semiconducteurs, notamment de silicium amorphe ou polycristallin déposé sur substrat isolant. Cette technologie fait l'objet, depuis quelques années, de nombreuses études, destinées à la réalisation d'empilements de couches alternativement monocristallines et isolantes. De telles structures permettent d'augmenter la densité d'intégration des circuits.

La difficulté essentielle que soulève cette technique concerne la réalisation d'un substrat monocristallin à partir d'une couche de silicium amorphe ou polycristallin déposée sur un isolant (typiquement oxyde ou nitrure supporté par une plaquette de silicium monocristallin). Par ailleurs, compte tenu des possibilités actuelles de la technologie du silicium, il est essentiel que le cristal obtenu soit orienté <100>.

Des tentatives de recristallisation ont été effectuées avec les lasers émettant en continu, mais compte tenu de la taille des spots disponibles avec ces sources et des problèmes de recouvrement des lignes fondues, cette solution paraît peu adaptée à des plaquettes de grande dimension (10 cm de diamètre).

Une autre solution connue consiste à utiliser une plaque de graphite chauffée par effet Joule et une baguette de graphite également chauffée par effet Joule, cette baguette étant déplacée à la surface du semiconducteur où elle fond une ligne étroite de silicium. Une telle technique est décrite dans l'article de J.C.C. FAN publié dans la revue «Applied Physics Letters» 40 (2), 15 Janvier 1982, page 158.

La machine de l'invention offre encore, dans ce domaine, des possibilités intéressantes. Par rapport à l'application au recuit, une adaptation doit être faite: la lampe défocalisée 20 doit porter le substrat à environ 1100 °C et la lampe focalisée 10–12 doit pouvoir fondre localement la couche de silicium. Les puissances des lampes sont donc plus fortes dans cette application que dans la précédente. On peut d'ailleurs utiliser comme seconde lampe disposée sous la plaquette à traiter, une lampe irradiant la quasitotalité ou même la totalité de la surface. Ce résultat peut être obtenu en utilisant un réflecteur parabolique dont le foyer est occupé par la lampe. Dans cette disposition, seule la première lampe est déplacée pour obtenir le balayage sur la plaquette.

Par ailleurs, il est connu, en cristallographie que, lors du tirage d'un cristal, la zone fondue doit présenter un front concave vis-à-vis de la zone recristallisée, afin d'éviter la nucléation sur les bords. La resolidification doit donc s'effectuer en priorité au centre de la zone fondue, ce qui permet de tirer de longs grains monocristallins.

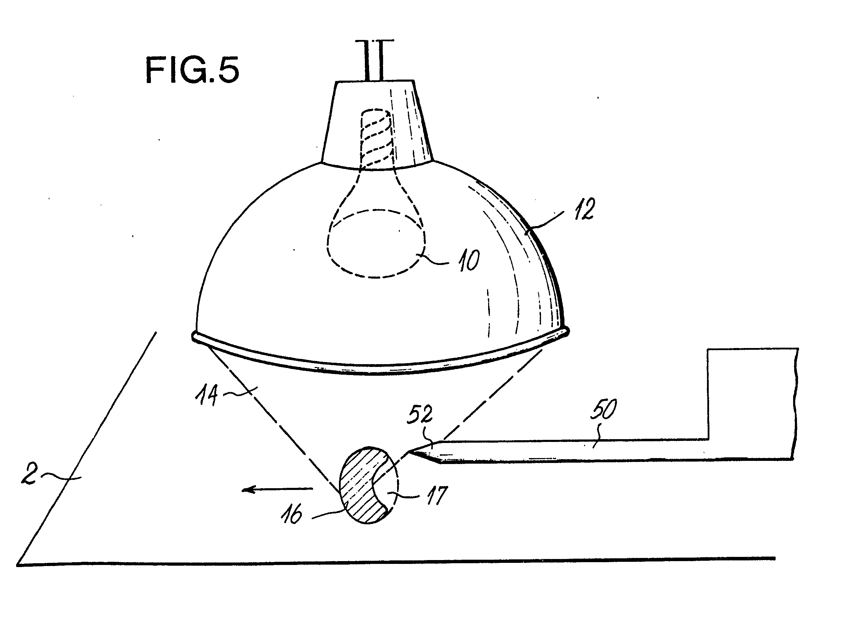

Cette forme particulière de la zone fondue peut être aisément obtenue en déformant la tache focale circulaire, conformément à ce qui est illustré sur la figure 5. Une tige 50, terminée par une pointe en platine 52, est placée dans le faisceau 14 émis par la première lampe très près de la plaquette. La pointe 52 constitue un masque qui porte ombre sur la plaquette et permet d'obtenir la forme en «haricot» 16 souhaitée. On pourrait naturellement employer d'autres moyens comme des masques, des réflecteurs, etc. . ., mais la solution illustrée semble particulièrement simple à mettre en œuvre.

Des essais de recristallisation ont été effectués avec une machine équipée suivant le schéma de la figure 5, avec les mêmes lampes que pour le recuit. La zone fondue était déplacée avec une vitesse de 0,5 à 1 mm/s dans un type de balayage ligne par ligne. Des grains visibles à l'œil nu ont été obtenus. Ces grains, monocristallins sont orientés <100> suivant la normale au plan de la plaquette et <100> dans la direction du balayage. Ces cristallites ont des dimensions typiques de 3 mm par quelques centimètres. La largeur est limitée par la taille du spot obtenu. Ces cristallites comportent des zones jointives faiblement désorientées (par rapport) à <100> dans le plan de la plaquette. La distribution angulaire des zones, séparées par des sous-joints est inférieure à 0,7° (typiquement 0,3°).

On remarquera que la largeur des grains obtenus(3 mm) est supérieure à celle qui est rapportée dans le dernier article cité, où elle n'est que de 2 mm. Par ailleurs, dans cet article, il est question d'une texture (100) dans la zone recristallisée alors que, avec la machine de l'invention, on obtient bien un monocristal <100>.

Les résultats mentionnés ont été obtenus avec des bandes découpées de 1 cm de large par quelques centimètres de long. Mais rien n'empêche d'utiliser des plaquettes circulaires de type industriel, de 10 cm de diamètre. Le balayage ligne par ligne doit s'effectuer avec un recouvrement des lignes de l'ordre de 10%, sans refonte des grains obtenus à la ligne précédente.

Naturellement, il va de soi que toutes les opérations qui viennent d'être décrites peuvent être réalisées avec des plaquettes en position verticale ou autre, de sorte que les mots «dessus» ou «dessous» n'ont pas de caractère limitatif, mais se rapportent simplement aux exemples illustrés où la plaquette est horizontale.

## Revendications

1. Machine de traitement thermique pour plaquettes de semiconducteur, comprenant des moyens pour chauffer localement une zone d'une des faces d'une telle plaquette et des moyens pour balayer cette zone sur la totalité de la plaquette, caractérisée en ce que les moyens pour chauffer localement une zone de la plaquette sont constitués par:

— une première lampe (10) munie d'un premier réflecteur focalisant (12), cette première lampe émettant un premier rayonnement (14) focalisé sur la face à traiter de la plaquette (2) selon une tache focale (16) ayant un certain diamètre,

— une seconde lampe (20) émettant un second rayonnement (24) dirigé vers l'autre face de la plaquette (2) et formant sur cette autre face une seconde tache (18) ayant un diamètre supérieur à celui de la tache focale et concentrique à cette tache focale.

2. Machine selon la revendication 1, caractérisée en ce que la seconde lampe (20) est munie d'un réflecteur (22) focalisant le second rayonnement (24) dans un plan (19) légèrement décalé par rapport à la seconde face de la plaquette (2).

3. Machine selon la revendication 1, caractérisée en ce que la seconde lampe (20) émet un rayonnement dirigé sur la totalité ou la quasitotalité de la seconde face de la plaquette (2).

4. Machine selon l'une quelconque des revendications 1 à 3, caractérisée en ce que les moyens de balayage de la zone chauffée sont constitués par des moyens de déplacement de l'ensemble des première et seconde lampes, la plaquette restant fixe.

5. Machine selon l'une quelconque des revendications 1 à 4, caractérisée en ce qu'elle comprend un support de plaquette permettant un traitement en atmosphère contrôlée, ce support comprenant un anneau isolant (4) pourvu de pointes isolantes (3) dirigées vers l'intérieur et aptes à supporter la plaquette sur sa périphérie, un premier conduit d'amenée de gaz (40) et un second conduit de sortie de ce gaz (42), ces deux conduits traversant l'anneau en des zones diamétralement opposées, deux hublots (44, 46) transparents étant appliqués sur l'anneau de part et d'autre de la plaquette.

6. Machine selon l'une quelconque des revendications 1 à 5, caractérisée en ce qu'elle comprend un moyen pour donner à la première tache focale une forme présentant une zone concave.

7. Machine selon la revendication 6, caractérisée en ce que le moyen en question est constitué par une tige (50) terminée par une pointe (52), cette pointe étant placée dans le rayonnement (14) émis par la première lampe (10) et portant ombre dans la tache focale, cette ombre dessinant la zone concave en question.

8. Machine selon la revendication 7, caractérisée en ce que la pointe (52) est en platine.

9. Procédé de traitement thermique de plaquettes de semiconducteur mis en œuvre au moyen de la machine selon les revendications 1 à 8, caractérisé en ce qu'on provoque un balayage en forme de spirale d'Archimède pour laquelle les coordonnées polaires r et $\varphi$ du centre de la première tache par rapport au centre de la plaquette vérifient la relation $r = a\varphi$ où $\underline{a}$ est une constante, et pour laquelle l'évolution temporelle de l'angle polaire $\varphi$ est de la forme $\underline{b}\sqrt{t}$ où $\underline{b}$ est une constante et $\underline{t}$ le temps, la vitesse linéaire de déplacement de la zone étant alors pratiquement constante.

## Patentansprüche

1. Vorrichtung zum thermischen Behandeln von Halbleiterplättchen, enthaltend Einrichtungen zum örtlichen Erwärmen einer Zone einer der Seiten eines solchen Plättchens und Einrichtungen zum Ablenken dieser Zone über die Gesamtheit des Plättchens, dadurch gekennzeichnet, dass die Einrichtungen zum örtlichen Erwärmen einer Zone des Plättchens gebildet sind durch

— eine erste Lampe (10), die mit einem ersten Sammelreflektor (12) versehen ist, wobei diese erste Lampe eine erste Strahlung (14) abgibt, die auf die zu behandelnde Seite des Plättchens (2) gemäss einem Fokussierfleck (16) eines gewissen Durchmessers fokussiert wird.

— eine zweite Lampe (20), die eine zweite Strahlung (24) abgibt, die gegen die andere Seite des Plättchens (2) gerichtet ist und auf dieser anderen Seite einen zweiten Fleck (18) ausbildet, der einen Durchmesser hat, der grösser als der Fokussierfleck ist und konzentrisch zu diesem Fokussierfleck ist.

2. Vorrichtung nach Anspruch 1, dadurch gekennzeichnet, dass die zweite Lampe (20) mit einem Reflektor (22) versehen ist, der die zweite Strahlung (24) in einer Ebene (19) bündelt, die gegenüber der zweiten Seite des Plättchens (2) leicht versetzt ist.

3. Vorrichtung nach Anspruch 1, dadurch gekennzeichnet, dass die zweite Lampe (20) eine Strahlung abgibt, die auf die Gesamtheit oder auf die Quasi-Gesamtheit der zweiten Seite des Plättchens (2) gerichtet ist.

4. Vorrichtung nach einem der Ansprüche 1 bis 3, dadurch gekennzeichnet, dass die Ablenkeinrichtungen für die erwärmte Zone von Verschiebeeinrichtungen der Anordnung aus den ersten und zweiten Lampen gebildet sind, wobei das Plättchen feststehend bleibt.

5. Vorrichtung nach einem der Ansprüche 1 bis 4, dadurch gekennzeichnet, dass sie enthält: einen Plättchenträger, der eine Behandlung in kontrollierter Atmosphäre erlaubt, wobei dieser Träger einen isolierenden Ring (4) aufweist, der mit isolierenden Spitzen (3) versehen ist, die nach innen gerichtet und dazu eingerichtet sind, das Plättchen an seinem Umfang abzustützen, eine erste Leitung (40) zur Zuführung von Gas und eine zweite Leitung (42) zur Abführung von Gas, wobei diese zwei Leitungen den Ring in zwei diametral gegenüberliegenden Bereichen durchqueren, wobei zwei transparente Sichtfenster (44, 46) zu beiden Seiten des Plättchens an dem Ring angebracht sind.

6. Vorrichtung nach einem der Ansprüche 1 bis 5, dadurch gekennzeichnet, dass sie eine Einrichtung enthält, mit der dem ersten Fokussierfleck eine Form gegeben wird, die einen konkaven Bereich aufweist.

7. Vorrichtung nach Anspruch 6, dadurch gekennzeichnet, dass die fragliche Einrichtung von einem Stift (50) gebildet ist, der in einer Spitze (52) endet, wobei diese Spitze in der Strahlung (14) angeordnet ist, die von der ersten Lampe (10) abgegeben wird und einen Schatten in dem Fokusfleck erzeugt, wobei dieser Schatten den fraglichen konkaven Bereich bestimmt.

8. Vorrichtung nach Anspruch 7, dadurch gekennzeichnet, dass die Spitze (52) aus Platin besteht.

9. Verfahren zur thermischen Behandlung von Halbleiterplättchen mit Hilfe einer Vorrichtung nach den Ansprüchen 1 bis 8, dadurch gekennzeichnet, dass man die Ablenkung in Form einer archimedischen Spirale hervorruft, für die die Polarkoordinaten r und $\varphi$ des Zentrums des ersten Flecks in bezug auf das Zentrum des Plättchens die Beziehung $r = a\varphi$ erfüllen, wo a eine Konstante ist, und für die die zeitliche Entwicklung des Polarwinkels $\varphi$ die Form $b\sqrt{t}$ hat, wobei b eine Konstante und t die Zeit ist, so dass die Lineargeschwindigkeit der Verschiebung der Zone praktisch konstant ist.

### Claims

1. Thermal treatment machine for semiconductor plates, which machine comprises means for locally heating a zone of one of the surfaces of such a plate and means for sweeping over this zone throughout the entire plate, characterized in that the means for locally heating a zone of the plate comprise:

a first lampe (10) provided with a first focussing reflector (12), this first lamp emitting a first radiation (14) focussed on the surface to be treated of the plate (2) according to a focal spot (16) having a certain diameter, and

a second lamp (20) emitting a second radiation (24) directed towards the other surface of the plate (2) and forming on this other surface a second spot (18) having a diameter exceeding that of the focal spot and concentric with this focal spot.

2. Machine according to Claim 1, characterized in that the second lamp (20) is provided with a reflector (22) focussing the second radiation (24) in a plane (19) which is slightly offset in relation to the second surface of the plate (2).

3. Machine according to Claim 1, characterized in that the second lamp (20) emits a radiation directed at the entire or almost the entire second surface of the plate (2).

4. Machine according to any one of Claims 1 to 3, characterized in that the means for sweeping over the heated zone comprise means for displacing the assembly of the first and second lamps, the plate remaining fixed.

5. Machine according to any one of Claims 1 to 4, characterized in that it comprises a plate support permitting a treatment in a controlled atmosphere, this support comprising an insulating ring (4) provided with insulating points (3) which are directed towards the interior and which are capable of supporting the plate on its periphery, a first gas supply duct (40) and a second outlet duct for this gas (42), these two ducts traversing the ring in diametrically opposite zones, two transparent windows (44, 46) being applied on the ring on both sides of the plate.

6. Machine according to any one of Claims 1 to 5, characterized in that it includes a means for imparting to the first focal spot a shape exhibiting a concave zone.

7. Machine according to Claim 6, characterized in that the means in question comprises a rod (50) terminated by a point (52), this point being placed in the radiation (14) emitted by the first lamp (10) and casting a shadow in the focal spot, this shadow defining the concave zone in question.

8. Machine according to Claim 7, characterized in that the point (52) is constructed of platinum.

9. Process for the thermal treatment of semiconductor plates, which process is carried out by means of the machine according to Claims 1 to 8, characterized in that sweeping is carried out in the form of an Archimedes spiral in respect of which the polar coordinates r and $\varphi$ from the centre of the first spot in realtion to the centre of the plate satisfy the relation $r = a\varphi$ where $\underline{a}$ is a constant, and in respect of which the temporal development of the polar angle $\varphi$ is of the form $b\sqrt{t}$ where $\underline{b}$ is a constant and $\underline{t}$ represents the time, the linear speed of displacement of the zone then being virtually constant.

1/4

# FIG.1

# FIG.2

# FIG.3

$$\frac{ds}{dt}$$

$$\frac{rd\varphi}{dt}$$

$$\frac{dr}{dt}$$

$$M$$

$$r$$

$$r = a\varphi$$

$$\varphi$$

$$O$$

$$x$$

# FIG.4

40

48

44

4

49

3

2

46

3

4

42

FIG.5

12

10

14

52

50

2

16

17